# EUROPEAN PATENT APPLICATION

(11) **EP 3 379 903 A1**
(43) Date of publication of application: **26.09.2018**
(21) Application number: 15911007.1
(22) Date of filing: 21.12.2015
(51) Int. Cl.: H05B 37/02, H03K 17/94

(54) **SWITCH CONTROL APPARATUS AND SWITCH CONTROL METHOD**

(71) Applicant: Shenzhen Royole Technologies Co., Ltd., Shenzhen, Guangdong 518172 (CN)
(72) Inventor: XIA, Xinyuan, Shenzhen, Guangdong 518052 (CN); XU, Rui, Shenzhen, Guangdong 518052 (CN); YANG, Songling, Shenzhen, Guangdong 518052 (CN); ZOU, Xiang, Shenzhen, Guangdong 518052 (CN); ZHOU, Yu, Shenzhen, Guangdong 518052 (CN); LIU, Zhanchao, Shenzhen, Guangdong 518052 (CN); WANG, Ji, Shenzhen, Guangdong 518052 (CN)
(74) Representative: Loo, Chi Ching
(86) International application number: PCT/CN2015/098058
(87) International publication number: WO 2017/107007

(57) **Abstract**

The invention discloses a switch control device (100), configured to control a plurality of objects (200). The switch control device (100) comprises a touch panel (10) and a controller (20). The touch panel (10) generates a touch signal in response to a user's touch gesture. The controller (20) determines a number of touch points according to the touch signal generated by the touch panel (10), and controls a corresponding number of the objects (200). The invention further discloses a switch control method. The switch control device and method of the present disclosure can quickly open a corresponding number of objects (200), without having to operate specific keys, which is convenient and quick.

## Description

### TECHNICAL FIELD

This disclosure relates to switch control devices, and more particularly relates to a switch control device and a switch control method that are controlled by touch inputs.

### BACKGROUND

Currently, the switch control device for controlling lamps and the like is usually provided with a plurality of mechanical keys for the user to control the lamps on/off, brightness, and the like. At present, some switch control devices are also provided with touch buttons. The user can control the lamps on or off by touching the corresponding touch buttons. However, whether the switch control device with mechanical keys or the switch control device with touch buttons, it is not particularly convenient for the user to recognize the positions of the keys/buttons and then operate the keys/buttons. In particular, for the lamp with multi-light sources, in order to independently control the light sources individually, a plurality of keys/buttons corresponding to the respective light sources are generally set on the switch. The user must operate the keys/buttons one by one to control each light source, and the process is thus cumbersome.

### SUMMARY

Embodiments of the present disclosure disclose a switch control device and a switch control method, which are capable of controlling corresponding objects by touch gestures, thereby simplifying operation.

An embodiment of the present disclosure discloses a switch control device configured to control a plurality of objects. The switch control device includes a touch panel and a controller. The touch panel generates a touch signal in response to a user's touch gesture. The controller determines a number of touch points according to the touch signal generated by the touch panel, and controls a corresponding number of the objects.

A switch control method, configured to control a plurality of objects. The switch control method includes steps: a touch panel generating a touch signal in response to a user' s touch gesture; a controller determining a number of touch points according to the touch signal generated by the touch panel; and the controller controlling a corresponding number of the objects.

The switch control device and method of the present disclosure can quickly control corresponding objects, without having to operate specific keys, which is convenient and quick.

### BRIEF DESCRIPTION OF THE DRAWINGS

To describe the technology solutions in the embodiments of the present disclosure more clearly, the following briefly introduces the accompanying drawings required for describing the embodiments. Obviously, the accompanying drawings in the following description show merely some embodiments of the present disclosure, those of ordinary skill in the art may also derive other obvious variations based on these accompanying drawings without creative efforts.
FIG. 1 is a diagram of a structure of a switch control device in accordance with an embodiment of the present disclosure;
FIG. 2 is a diagram of a specific circuit of a switch circuit in accordance with an embodiment of the present disclosure;
FIG. 3 is a perspective, schematic diagram of a switch control device in accordance with an embodiment of the present disclosure;
FIG. 4 is an exploded view of a switch control device in accordance with an embodiment of the present disclosure;
FIG. 5 is a schematic view of a back of a support plate of a switch control device in accordance with an embodiment of the present disclosure;
FIG. 6 is a flowchart of a switch control method in accordance with an embodiment of the present disclosure.

### DETAILED DESCRIPTION

The technical solution in the embodiments of the present disclosure will be described clearly and completely hereinafter with reference to the accompanying drawings in the embodiments of the present disclosure. Obviously, the described embodiments are merely some but not all embodiments of the present disclosure. All other embodiments obtained by a person of ordinary skilled in the art based on the embodiments of the present disclosure without creative efforts shall fall within the protection scope of the present disclosure.

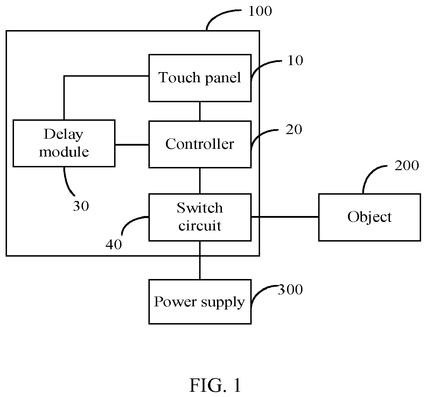

Referring to FIG. 1, FIG. 1 is a block diagram of a switch control device 100 in accordance with an embodiment of the present disclosure. The switch control device 100 is configured to control at least one object 200. The switch control device 100 includes a touch panel 10, a controller 20. The controller 10 is configured for the user to perform touch operations. Wherein, the touch panel 10 generates corresponding touch signals in response to user's touch operations. The controller 20 is electrically coupled between the touch panel 10 and the at least one object 200. The controller 20 is configured to confirm the number of the touch points according to the touch signals generated by the touch panel 10, and further control a corresponding number of objects 200 to open according to the number of the touch points.

In this embodiment, the number of the at least one object 200 is five. When the controller 20 determines that the number of the touch points is one, one object 200 is controlled to turn on. When it determines that the number of the touch points is two, two objects 200 are controlled to turn on. When it determines that the number of the touch points is three, three objects 200 are controlled to turn on. When it determines that the number of the touch points is four, four objects 200 are controlled to turn on. When it determines that the number of the touch points is five, five objects 200 are controlled to turn on.

Understandably, when there are a large number of objects 200, the number of touch points may also be in a one-to-many multiple relationship with the objects 200. For example, when there are fifteen objects 200, one touch point corresponds to three objects 200. That is, when one touch point is detected, three objects 200 are turned on; when two touch points are detected, six objects 200 are turned on, and so on.

Therefore, the present disclosure can quickly open the corresponding number of objects 200 without having to operate specific keys, which is convenient and quick.

Wherein, in the present disclosure, the touch point refers to an independent continuous area. For example, when the user touches with one finger, the touched area is a touch point. Therefore, when the user touches the touch panel 10 with a certain number of fingers, the number of touch points determined by the controller 20 is the number of fingers, and a corresponding number of objects 200 are controlled to turn on according to the number of the fingers.

The controller 20 also determines a touch trace according to the touch signal, and further controls a parameter of the object 200. Specifically, the controller 20 determines a moving relationship of relative positions of the touch points according to the touch signal, and increases or decreases the parameter of the object 200. In this embodiment, when the controller 20 determines that the number of touch points is at least two, and the movement traces of the touch points are away from each other, the controller 20 controls to increase the specific parameter of the object 200 currently turned on. When the controller 20 determines that the number of touch points is at least two and the movement traces of the touch points are close to each other, the controller 20 controls to decrease the specific parameter of the object 200 currently turned on. Preferably, the control of the specific parameter is optimized for two-finger operations to simplify the user's operations.

In this embodiment, each object 200 is a lamp. A plurality of objects 200 constitute a combination luminaire. The specific parameter is brightness. The controller 20 controls the corresponding number of lamps to turn on according to the number of fingers touched by the user, and controls to increase the brightness of the objects 200 when determining that the user's touch operation is a close operation of multiple fingers away from each other, and controls to decrease the brightness of the objects 200 when determining that the user's touch operation is a converging operation of a plurality of fingers close to each other.

In another embodiment, the object 200 can also be a loudspeaker or a sound box. A plurality of objects 200 constitute a combination speaker. The specific parameter is volume. The controller 20 controls the corresponding number of sound boxes to turn on according to the number of fingers touched by the user, and controls to increase the volume of the objects 200 when determining that the user's touch operation is the separation operation of multiple fingers away from each other, and controls to decrease the volume of the objects 200 when determining that the touch operation is the converging operation of a plurality of fingers close to each other. In other embodiments, the object 200 may also be a television, a display, and the like.

Therefore, the present disclosure can quickly adjust the parameter of the object 200 without having to operate specific keys, which is convenient and quick.

In this embodiment, the controller 20 also controls to turn off all the objects 200 when it is determined that the touch operation input through the touch panel 10 is a double-click operation. Wherein, when the controller 20 determines that two touches occur at the same position within a predetermined time interval (for example, 1 second) according to the touch signal, it is determined that the touch operation is the double-click operation, and all the objects 200 are controlled to turn off. Wherein, the user can perform the double-click operation with at least one finger.

In this embodiment, in order to prevent misjudgment, the switch control device 100 further includes a delay module 30. The delay module 30 may be a module integrated in the controller 20, or a module connected between the touch panel 10 and the controller 20. The delay module 30 is configured to generate a delay period so that all successive operations within the delay period are counted and finally executed simultaneously. For example, when the user wants to open the three objects 200 at the same time, since the length of the fingers is not equal, it is difficult to avoid that some fingers touch the touch panel 10 first, and some other fingers touch the touch panel 10 afterwards. If the delay function is not added but the command is executed immediately, the three objects 200 will be opened in a successively manner, causing a bad impression to the user. After adding the delay function, the controller 20 will not execute the command immediately but will execute the command after the delay period elapses. Thus, even if the touch panel 10 is successively touched, as long as the touches are completed within the delay period, the controller 20 regards the touches simultaneously performed, thereby executing the command to simultaneously turn on the plurality of objects 200 after the delay period has elapsed. Preferably, the delay period is 1 second. When the delay module 30 is integrated in the controller 20, the controller 20 directly receives the touch signals from the touch panel 10 and executes the command after the delay period. When the delay module 30 is located outside the controller 20, the delay module 30 receives the touch signal of the touch panel 10, and then sends the signal to the controller 20 to execute the command after the delay period.

The controller 20 also controls to turn off the delay module 30 when there are objects turned on, so that the double-click operation for closing the object 200, and gathering or separating actions for increasing or decreasing the parameter of the object 200 can be responded in time.

Wherein, the touch panel 10 can be located on at least one surface of the switch control device 100. In one embodiment, the touch panel 10 can also be a panel that passes through a body of the switch control device 100 in a slantwise insertion manner. The touch panel 10 includes a flexible touch panel, and any position of its touch surface can be used as a touch gesture input position. Also, a touch gesture performed at an arbitrary angle on the touch surface of the flexible touch panel with respect to one side of the touch surface may be sensed by the touch panel 10, and then recognized by the controller 20 and converted into a control signal to control the object 200. For example, the two fingers gathering together in a horizontal direction, the two fingers gathering together in a vertical direction, and the two fingers gathering along a diagonal line, and the like may be all recognized by the controller 20 as an instruction to reduce the brightness of the object 200.

As shown in FIG. 1, the switch control device 100 further includes a switch circuit 40. The switch circuit 40 is coupled to a power supply 300 and all objects 200. The switch circuit 40 is configured to turn on or turn off electrical connections between the corresponding objects 200 and the power supply 300 in response to the control of the controller 20, thereby turning on or turning off the corresponding objects 200.

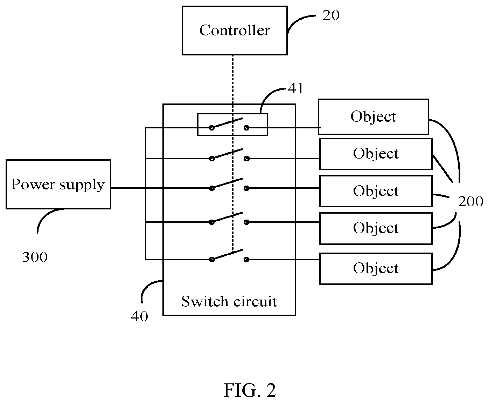

Please refer to FIG. 2, which is a diagram of a specific circuit of the switch circuit 40. The switch circuit 40 includes at least one switch 41. The number of the switches 41 is the same as the number of objects 200. For example, as shown in FIG. 2, the number of switches 41 is five. Each switch 41 is coupled between the power supply 300 and a corresponding object 200. The controller 20 is connected to each switch 41 for controlling the corresponding number of switches 41 to be turned on according to the number of touch points, so that the objects 200 connected to the switches 41 that are turned on receives the power supply voltage from the power supply 300 and turn on. Wherein, each switch 41 can be a numerical control switch.

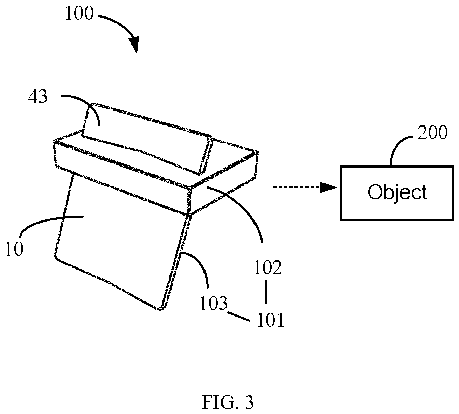

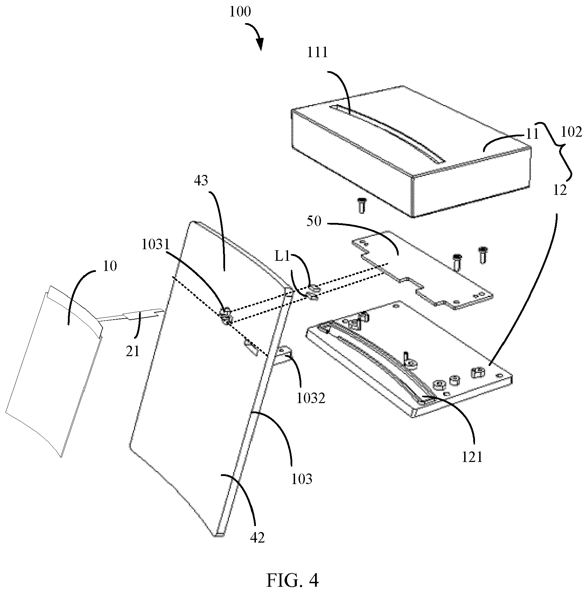

Please referring to FIGS. 3 and 4, FIG. 3 is a perspective diagram of a switch control device 100 in accordance with an embodiment of the present disclosure. The switch control device 100 further includes a supporter 101 and a circuit board 50. The supporter 101 includes a base 102 and a support plate 103. Wherein, the touch panel 10 is a flexible touch panel that is attached to a surface of the support plate 103. The support plate 103 having the touch panel 10 attached thereto is inserted into the base 102, and the portion of the touch panel 10 is exposed.

The touch panel 10 is an arc-shaped structure, such as similar to a 1/4-perimeter side surface of cylinder. The support plate 103 is also an arc-shaped structure conforming to the touch panel 10. In this embodiment, the support plate 103 is an arc-shaped structure as a whole, that is, the surface of the support plate 103 on which the touch panel 10 is attached is an arc-shaped surface conforming to the touch panel 10, and the other surface on the opposite side is also arc-shaped. In other embodiments, the surface of the supporting plate 103 on which the touch panel 10 is attached is a curved surface, and the other surface may be a flat surface or other structures.

Wherein, as shown in FIG. 3, after the support plate 103 is inserted into the base 102, the support plate 103 is divided into two parts by the base 102. A part of the support plate 103 exposes at a bottom of the base 102 is a functional area 42 (as shown in FIG. 2). The flexible touch plate 20 is attached to the functional area 42, and the other part is a decorative area 43 exposed on a top of the base 102.

As shown in FIG. 3, the touch panel 10 is covered on the functional area 42 in a lower area of the support plate 103. The decoration area 43 is located in an upper area of the support plate 103, and a covering area of the touch panel 10 is significantly larger than an area of the decoration area 43. For example, the touch panel 10 covers three times the area of the decoration area 43. The left and right sides of the touch panel 10 are close to the left and right sides of the functional area 42, the lower end terminates at the lower end of the functional area 42, and the upper end terminates outside the decorative area 43.

Please refer to FIG. 4, which is an exploded view of the switch control device 100. The base 102 includes a housing 11 and a base plate 12 fixed to the bottom of the housing. The housing 11 and the base plate 12 form a substantially closed space, for example, forming a rectangular parallelepiped.

The housing 11 defines a first slot 111. The base plate 12 defines a second slot 112 in a portion of the base plate 12 corresponding to the first slot 111. The support plate 103 with the touch panel 10 attached thereto is inserted into the base 102 through the first slot 111 and the second slot 112. In the present embodiment, the first slot 111 and the second slot 112 are offset by a certain distance in the horizontal direction, so that the support plate 103 is obliquely inserted in the base 102.

Wherein, the first slot 111 and the second slot 112 are arc-shaped slots, which are compatible with the shape of the support plate 103.

Wherein, the slot edge of the second slot 112 on the base plate 12 is provided with an upper flange protruding upwardly, and the slot edge of the first slot 111 of the housing 11 is correspondingly provided with a lower flange protruding downwardly, for isolating the support plate 103 with the touch panel 10 attached thereto from the circuit board 50 and the like located on the base plate 12, and can guide an insertion direction of the support plate 103 at the same time.

The circuit board 50 is fixed to the base plate 12 by screws. The support plate 103 defines an opening 1031 therein. A flexible circuit board 21 is mounted on the surface of the touch panel 10 facing the support plate 103. The flexible circuit board 21 is electrically coupled to the circuit board 50 through the opening 1031.

Wherein, as shown in FIG. 4, the circuit board 50 is further provided with at least one indicator L1 for generating light indicating the position of the switch control device 100.

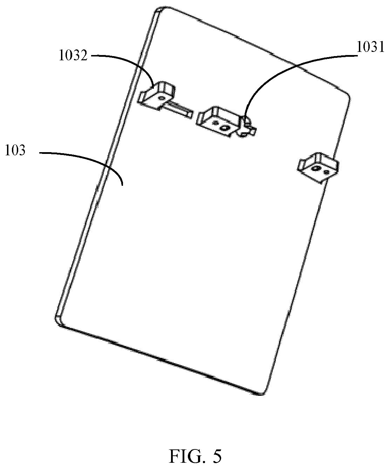

Please referring to FIG. 5 together, wherein, in this embodiment, the opening 1031 is a cross-shaped opening formed by intersecting a horizontal through slot and a vertical through slot. The number of the indicators L1 is two, which are respectively embedded at two opposite ends of the vertical through slot of the opening 1031. The indicator L1 may be an LED lamp. The indicator L1 is accommodated obliquely at the two opposite ends of the vertical through slot, and emits light toward the decoration area 43 and the functional area, respectively. The support plate 103 is made of a transparent material such as acrylic to play a role of a light guide plate. The touch panel 10 is also made of a transparent material. The light emitted from the indicator L1 which is embedded in the opening 1031 is guided to the entire support plate 103, and the position of the touch panel 10 can be prompted to the user. As shown in FIG. 2, the flexible circuit board 21 extends through the horizontal through slot of the opening 1031 to the circuit board 50 and is electrically coupled to the circuit board 50.

The back surface of the support plate 103 without attaching the touch panel 10 thereto is provided with a fixing member 1032. The fixing member 1032 is configured to fix the support plate 103 to the base plate 12. As shown in FIG. 3, in this embodiment, the fixing member 1032 includes at least one fixing post each having a screw hole, and the supporting plate 103 is fixed to the base plate 12 by screws. Obviously, in other embodiments, the fixing member 1032 may also be a connecting member such as a hook, and the supporting plate 103 is fixed to the base plate 12 through locking.

Wherein, the controller 20 and the switch circuit 40 are located on the circuit board 50.

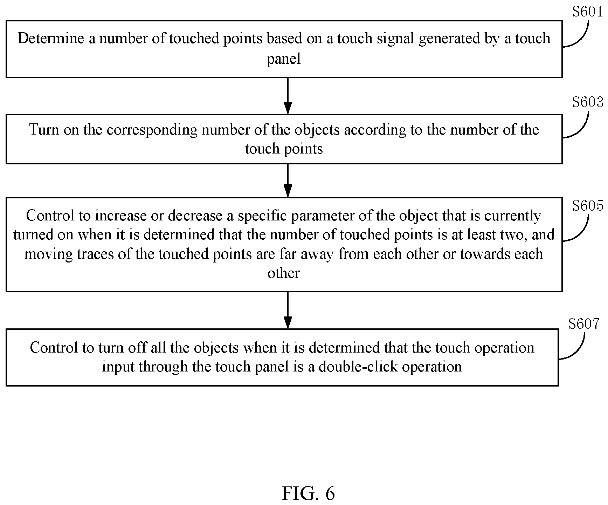

As shown in FIG. 6, FIG. 6 is a flowchart of the switch control method in accordance with an embodiment of the present disclosure. The method is a method for the switch control device 100 controlling the at least one object 200. The method includes the following steps:

The controller 20 determines the number of touched points based on the touch signal generated by the touch panel 10 of the switch control device 100 (S601).

The controller 20 turns on the corresponding number of the objects 200 according to the number of the touch points (S603).

When the controller 20 determines that the number of touched points is at least two, and the moving traces of the touched points are far away from each other or towards each other, the controller 20 controls to increase or decrease a specific parameter of the object 200 that is currently turned on (S605).

When the controller 20 determines that the touch operation input through the touch panel 10 is a double-click operation, the controller 20 controls to turn off all the objects 200 (S607).

It can be understood that the terms "many" and "a plurality" in the present disclosure refer to two or more cases.

The above is a preferred embodiment of the present disclosure, and it should be noted that those skilled in the art may make some improvements and modifications without departing from the principle of the present disclosure, and these improvements and modifications are also the protection scope of the present disclosure.

## Claims

1. A switch control device, being operable to control a plurality of objects, wherein, the switch control device comprising:
a touch panel, generating a touch signal in response to a user's touch gesture; and
a controller, determining a number of touch points according to the touch signal generated by the touch panel, and controlling a corresponding number of the objects.

2. The switch control device according to claim 1, wherein, the controller further determines a touch trace according to the touch signal, thereby controlling a parameter of the object.

3. The switch control device according to claim 2, wherein, the controller increases or decreases the parameter of the object according to a movement relationship of relative positions of the touch points determined according to the touch signal.

4. The switch control device according to claim 2, wherein, the controller recognizes a touch trace with an arbitrary angle and converts the touch trace into a control signal to control the object.

5. The switch control device according to claim 3, wherein, the object comprises a lamp, and the controller reduces a brightness of the lamp when the touch points are determined to move towards each other according to the touch signal, and the controller increases the brightness of the lamp when the touch points are determined to move away from each other according to the touch signal.

6. The switch control device according to claim 1, wherein, the controller also determines touch times according to the touch signal and controls all the objects at the same time.

7. The switch control device according to claim 6, wherein, when the controller determines that the touch gesture is a double-click operation according to the touch signal, and simultaneously closes all the objects.

8. The switch control device according to claim 1, further comprising a delay module that generates a delay period, wherein the touch signal occurred within the delay period is delayed until the delay period expires.

9. The switch control device according to claim 1, wherein, the control panel comprises a flexible touch pad, and the touch gesture is input anywhere on a touch surface of the flexible touch pad.

10. A switch control method, to control a plurality of objects, the switch control method comprising:
a touch panel generating a touch signal in response to a user's touch gesture;
a controller determining a number of touch points according to the touch signal generated by the touch panel; and
the controller controlling a corresponding number of the objects.

11. The switch control method according to claim 10, wherein, the controller increases or decreases a parameter of the object according to a relative position movement relationship of the touch points determined according to the touch signal.

12. The switch control method according to claim 10, wherein, when the controller determines that the touch gesture is a double-click operation according to the touch signal, it simultaneously closes all the objects.

13. The switch control method according to claim 10, further comprising steps :
recording all the touch signals that occur within a delay period and then executing a command according to the touch signals after the delay period expires.
